(19) Europäisches Patentamt
European Patent Office
Office européen des brevets

(11) Veröffentlichungsnummer : **0 326 918 B1**

(12) # EUROPÄISCHE PATENTSCHRIFT

(45) Veröffentlichungstag der Patentschrift :
**18.03.92 Patentblatt 92/12**

(51) Int. Cl.$^5$ : **C23C 18/22,** C23C 18/24

(21) Anmeldenummer : **89101244.5**

(22) Anmeldetag : **25.01.89**

(54) **Verfahren zum Metallisieren von Formkörpern aus Polyarylensulfid.**

(30) Priorität : **03.02.88 DE 3803167**

(43) Veröffentlichungstag der Anmeldung :
**09.08.89 Patentblatt 89/32**

(45) Bekanntmachung des Hinweises auf die Patenterteilung :
**18.03.92 Patentblatt 92/12**

(84) Benannte Vertragsstaaten :
**DE FR GB IT**

(56) Entgegenhaltungen :
**US-A- 3 354 129**
**US-A- 4 447 471**
**PATENT ABSTRACTS OF JAPAN, Band 11, Nr. 101 (C-413)[2548], 31. März 1987; & JP-A-61 250 175 (TORAY IND. INC.) 07-11-1986**

(73) Patentinhaber : **BAYER AG**
**W-5090 Leverkusen 1 Bayerwerk (DE)**

(72) Erfinder : **Sirinyan, Kirkor, Dr.**
**Humperdinckstrasse 12**
**W-5060 Bergisch-Gladbach 2 (DE)**
Erfinder : **Reinking, Klaus, Dr.**
**Robert-Stolz-Strasse 16 B**
**W-5632 Wermelskirchen 1 (DE)**
Erfinder : **Köhler, Karl-Heinz, Dr.**
**Buschstrasse 165**
**W-4150 Krefeld 1 (DE)**
Erfinder : **Wehnert, Wolfgang, Dr.**
**Bodelschwinghstrasse 14**
**W-4150 Krefeld 1 (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 326 918 B1

## Beschreibung

Gegenstand der Erfindung ist ein Verfahren zum naßchemischen Metallisieren von gegebenenfalls faserverstärkten und füllstoffhaltigen Polyarylensulfiden.

Auf diesem Arbeitsgebiet liegt ein derart umfangreiches Schrifttum vor, so daß nachstehend nur die wichtigsten Literaturstellen kurz abgehandelt werden:

US-A 4 615 907 betrifft die Vorbehandlung mit Laserstrahlen.

EP-A 0 229 344 betrifft die Vorbehandlung mit Licht der Wellenlängen von 0,1 nm - 800 nm.

US-A 3 616 186 betrifft die Vorbehandlung mit stickstoffhaltigen Verbindungen.

US-A 4 011 121 betrifft eine Flammenvorbehandlung.

JP-A 62/63674 betrifft die Vorbehandlung mit fluorhaltigen Oxidantien die Glasfasern angreifen.

US-A 3 953 653 betrifft die oxidative Vorbehandlung mit anschließender Auflaminierung von Metallfolien.

US-A 4 532 015 betrifft Verbesserung der Haftfestigkeit der Metallauflagen durch Alterung.

US-A 4 395 512 betrifft Verbesserung der mechanischen Eigenschaften von z.B. gedruckten Schaltungen durch Einbau von Fluorkautschuk.

US-A 4 389 453 betrifft Herstellung von gedruckten Schaltungen durch Auflaminieren von Cu-Folien auf durch bestimmte Glasfasern verstärkte Substrate.

EP-A 0 229 495 betrifft die Verbesserung der Haftfestigkeit von Metallauflagen durch Einarbeiten von Kaliumtitanatfasern.

Die Vorstehend genannten Verfahren weisen jedoch durchweg diverse Mängel auf, indem sie zu aufwendig sind und/oder zu geringe Haftfestigkeiten der Metallbeschichtungen ergeben.

Es wurde nun gefunden, daß man auf einfache Weise, d.h. ohne Strahleneinwirkung und ohne Vorbehandlung mit organischen Lösungsmitteln, Flammen, und/oder mechanischen Aufrauhungsvorrichtungen, naßchemisch zu gut haftenden Metallauflagen gelangt, wenn man auf die Formkörper vor der Aktivierung ein Glas nicht-ätzendes Oxidationsmittel einwirken läßt und die Formkörper aus solchen Polyarylensulfiden bestehen, die als Füllstoffe Titandioxid und/oder Magnesiumcarbonat enthalten.

Dieser Befund muß ale überraschend angesehen werden, da mit den besonders häufig eingesetzten Füll- bzw. Verstärkungsmitteln, wie Calciumcarbonat und/oder Glasfasern, weniger gute Effekte erzielt werden.

Wegen der bekanntermaßen hervorragenden thermischen, mechanischen und dielektrischen Eigenschaften der Polyarylensulfide, eignet sich das neue Verfahren gemäß einer bevorzugten Variante besonders zum partiellen Metallisieren von Polyarylensulfid-Formkörpern zwecks Herstellung von gedruckten Schaltungen.

Geeignete Polyarylensulfide sind insbesondere Polyphenylensulfide, wie sie in der oben abgehandelten und nachstehend zitierten Patentliteratur beschrieben sind:

US-A 2 513 188, US-A 2 538 941, US-A 3 291 779, vorzugsweise US-A 3 354 129, US-A 4 038 261, US-A 4 038 259, US-A 4 038 263, US-A 4 038 262, US-A 4 046 114, US-A 4 038 260, US-A 4 116 949, EP-A 56 690, EP-A 119 607 und EP-A 171 021.

Man erhält diese Polymeren nach an sich bekannten Methoden, insbesondere durch Umsetzung von di- oder polychlorierten Phenolen mit $Na_2S$ in hochsiedenden Lösungsmitteln.

Beispielhaft seien folgende Polymeren genannt:
Poly-2,4-tolylen-sulfid, Poly-phenylensulfid, Poly-4,4-biphenylensulfid bzw. deren teilverzweigte und/oder vernetzte Typen (bvgl. beispielsweise US-Patent 3 324 087) bzw. deren Cokondensate mit mono-, di- oder poly-Chlorbenzolsulfonsäure, -benzoesäure usw.. Das letztgenannte wird zur Durchführung des Verfahrens besonders bevorzugt eingesetzt.

Geeignete Polymere sind auch deren Mischungen mit thermoplastischen Polycarbonaten, Polyamiden, Polyphenylenoxiden, und/oder Polyestern (vgl. beispielsweise JP-A 41 022 192 und EP-A 87 038).

Die Füllstoffe weisen eine durchschnittliche Partikelgröße von 0,01-50 μm, vorzugsweise 1,0-8,0 μm, besonders bevorzugt 2-3 μm. Selbstverständlich können die besagten Füllstoffe im idealen Fall in der Matrix molecular gelöst bzw. dispgergiert vorliegen. Gewöhnlich beträgt der Füllstoffanteil etwa 1-90 Gew.-%, vorzugsweise 7,5-40 Gew.-% besonders bevorzugt 10-30 Gew.-% des Gesamtgewichtes von Polymer und Füllstoff.

Geeignete Oxidationsmittel zur Durchführung des erfindungsgemäßen Verfahrens sind vorzugsweise 2 %ige wäßrige $Br_2$-Lösungen, konz. $H_2SO_4$ (Dichte = 1,84 g/cm³) oder Chromschwefelsäure bestehend aus beispielsweise 0,1-30 g/l $Na_2Cr_2O_7$ oder bestehend aus beispielsweise 0,1-40 g/l $Na_2Cr_2O_7$, 200 ml $H_2O_{dest.}$, 600 ml $H_2SO_{4konz.}$ und 200 ml $H_3PO_{4konz.}$ oder organische Persäuren wie

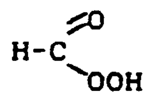 , 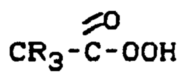

R = H, Cl, Br, J und vorzugsweise F oder Peroxobenzolsulfonsäure, Benzolsulfonsäure und $H_2O_2$ oder $H_2O_2$ in Hexafluor- oder Trifluoraceton.

Die Behandlung kann in einem Temperaturbereich von -15°C bis zum jeweiligen Siedepunkt des besagten Oxidationsmediums, vorzugsweise jedoch in einem Bereich von +15 bis +60°C und ganz besonders bevorzugt in einem Bereich von +15°C bis +40°C im Verlaufe von 0,5-90 Minuten, vorzugsweise jedoch 1-10 Minuten, besonders bevorzugt 5-7, Minuten erfolgen.

Mit Hilfe der nach dem erfindungsgemäßen Verfahren abgeschiedenen Metallauflagen, können spritzgegossene Leiterplatten sowohl nach bekanntem Semi-Additiv- als auch Voll-Additiv-Verfahren hergestellt werden.

Zur Herstellung von Leiterplatten nach dem Voll-Additiv-Verfahren werden die Formkörper gegebenenfalls mit Löchern versehen, mit den besagten Oxidationsmitteln behandelt, aktiviert, gegebenenfalls sensibilisiert, anschließend mit einer Maske auf der Basis von Siebdruckpasten oder Photolacken versehen und dann auf die maskenfreien Stellen auf naßchemischem Wege eine Metallauflage der Schichtdicke 5 - 40 µm abgeschieden.

Bei der technischen Durchführung des Verfahrens kann selbstverständlich die Reihenfolge des Maskierungsschrittes - ob vor oder nach dem Aktivieren oder Sensibilisieren - beliebig variiert werden. In diesem Zusammenhang sei erwähnt, daß durch die oxidative Behandlung und gegebenenfalls durch eine anschließende Temperung die Haftung der Metallauflage überraschenderweise erheblich verbessert wird.

Bevorzugte Metallauflagen sind Kupferbeschichtungen.

Zur Herstellung von Leiterplatten nach dem Semi-Additiv-Verfahren werden die Formkörper gegebenenfalls mit Löchern versehen, nach dem bereits beschriebenen Verfahren mit einer durchgehenden Metallauflage der Schichtdicke 0,1-10 µm vorzugsweise 0,5-2,0 µm metallisiert, anschließend wie bereits angegeben mit einer Maske auf Siebdrucklack- oder Photolackbasis versehen, die maskenfreien Stellen auf 12-70 µm vorzugsweise jedoch auf 17,5-40 µm verstärkt, die Maske chemisch oder mechanisch von der Oberfläche entfernt und dann die elektrisch leitende Metallauflage vorzugsweise durch Differenzätzen von der Probenoberfläche entfernt. Zur galvanischen Verstärkung können übliche Metalle wie Ni, Cu, Co, Ag und Au bzw. deren Mischungen untereinander eingesetzt werden. Das bevorzugte Metall ist Kupfer.

Die vor der Metallisierung vorzunehmende Aktivierung erfolgt - gegebenenfalls nach einer "Entgiftung" mit z.B. einer Bisulfitlösung - mit üblichen kolloidalen oder ionogenen Aktivierungssystemen, vorzugsweise auf der Basis von Palladium.

Besonders geeignet als Aktivatoren sind darüber hinaus metallorganische Komplexverbindungen von Edelmetallen wie sie z.B. in EP-A 81 129 und 82 438 sowie in US-A 4 636 441 und 4 006 047 sowie in DE-A 2 116 389 und 2 451 217 beschrieben sind. Bevorzugt sind Pd-Komplexe.

An die Aktivierung kann sich gewünschtenfalls eine Sensibilisierung mittels $SnCl_2$- oder $ZnCl_2$-Lösungen anschließen.

Für die Metallisierung kommen die in der Literatur ausführlich beschriebenen und vor allem die im Handel erhältlichen Bäder in Betracht. Nach der Metallisierung empfiehlt sich häufig eine Temperung im Bereich zwischen Glasumwandlungstemperatur und Erweichungspunkt, d.h. zwischen etwa 90 und 250°C, vorzugsweise 120 und 170°C. Die Temperungszeit kann breit variiert werden und beträgt vorzugsweise 40-80 Minuten.

Die erfindungsgemäß erhältlichen Metall-Verbundwerkstoffe weisen eine Metallauflage nach DIN 534 96 von mindestens 10 N/inch, üblicherweise 15-30 N/inch, in Sonderfällen 35-60 N/inch auf. Diese Werkstoffe zeichnen sich durch ihre gute Wärmeleitfähigkeit und hervorragende Abschirmung gegenüber den elektromagnetischen Störwellen aus. Sie können sowohl im Automobilsektor als auch im Elektro- und Elektronikbereich eingesetzt werden.

Besonders bevorzugt ist die Anwendung des neuen Verfahrens zur Herstellung von Feinstleiterplatten mit Bahnbreiten $\leqq$ 200 µm nach der Differenzätzmethode.

In den nachfolgenden Beispielen bedeutet "PPS" Polyphenylensulfid.

## Beispiel 1

Eine spritzgegossene PPS-Platte (45 % PPS mit COOH-Endgruppen, 45 % Glasfasern und 10 % $MgCO_3$) (200 x 200 x 1 mm) wird in einem Bad bestehend aus
8,5 g $Na_2Cr_2O_7$ und

100 ml $H_2SO_4$ ($\rho$ = 1,84 g/cm$^3$)
bei RT 5 Min. vorbehandelt, mit $H_2O_{dest.}$ gewaschen, getrocknet, in einer Lösung bestehend aus
0,5 g Mesityloxidpalladiumchlorid
1000 ml $CCl_2 = CCl_2$
bei RT 5 Min. aktiviert, getrocknet,
in einer Lösung bestehend aus
1,0 g NaOH, 8,0 g DMAB (Dimethylaminboran)
1000 ml $H_2O_{dest.}$ sensibilisiert,
mit $H_2O_{dest.}$ gewaschen und dann in einem Ni-Bad der Schering AG, 1000 Berlin, im Verlaufe von 30 Min. mit einer Ni-Auflage versehen. Anschließend wird diese Platte bei 150°C 1h getempert.

Man bekommt einen Verbundwerkstoff mit guter Metallhaftung. Die Haftfestigkeit der Metallauflage, bestimmt durch die Abzugskraft nach DIN 53 496, beträgt ≧ 25 N/25 mm.

Die galvanische Verstärkung von der o.a. PPS-Platte für die Bestimmung der Abzugskraft wurde wie folgt durchgeführt:

a) eine halbe Minute dekapieren in 10 %iger $H_2SO_4$
b) Spülen
c) 5 Minuten im Halbglanznickelbad, Spannung 3 Volt, Badtemperatur 60°C
d) Spülen
e) eine halbe Minute dekapieren,
f) 90 Minuten im Kupferbad, Spannung 1,3 Volt, Badtemperatur 28°C
g) Spülen

Die Metallauflage besteht den Lötbadtest.

Die so hergestellte Platte wird mit einer partiellen Maske (Siebdruckverfahren) versehen, die maskenfreien Stellen auf galvanischem Wege auf 40 µm verstärkt, die Maske in $CH_2Cl_2$ von der PPS-Oberfläche entfernt und dann die restliche Ni-Auflage in einem Bad bestehend aus

| | |
|---|---|
| 3 g | $FeCl_2$ |
| 15 ml | HCl |
| 500 ml | $H_2O_{dest.}$ |

durch Differenzätzen von der Oberfläche entfernt. Man bekommt eine spritzgegossene Leiterplatte mit hervorragenden elektrischen und thermischen Eigenschaften.

Beispiel 2

Eine im Beispiel 1 angegebene PPS-Platte wird in einer Lösung bestehend aus

250 ml $CF_3-\overset{O}{\overset{\|}{C}}-O-OH$
100 ml $H_2O_{dest.}$

bei RT im Verlaufe von 5 Minuten vorbehandelt, mit $H_2O_{dest}$ gewaschen
in einem Bad bestehend aus
1,0 g Bisbenzonitrilpalladiumdichlorid

1000 ml $CH_3-\underset{O}{\underset{\|}{C}}-CH_3$

aktiviert, getrocknet und dann nach Beispiel 1 sensibilisiert.

Anschließend wird die Platte in einem handelsüblichen Cu-Bad der Shiplay AG, D-7000 Stuttgart, im Verlaufe von 50 Minuten verkupfert. Anschließend wird die Platte nach Beispiel 1 mit Hilfe eines Photoresists der Fa. BASF AG, nach dem Differenzverfahren mit Leiterbahnen versehen. Die anschließend bei 170°C getemperte Platte weist eine Metallhaftung von ≧ 30 N/inch auf. Die Metallauflage haftet auf der PPS-Oberfläche so gut, daß sie den Lötbadtest besteht.

Beispiel 3

Eine herkömmliche 45 % glasfaserverstärkte PPS-Platte, die noch zusätzlich $MgCO_3$ 10% enthält, wird in einer Lösung bestehend aus

| | |
|---|---|
| 5 g | $CrO_3$ |
| 1000 ml | $H_2SO_4$ ($\rho$ = 1,84 g/cm³) |

5 Minuten bei 80°C vorbehandelt,
in einem kolloidalen Aktivator der Fa. Blasberg AG, in D-5650 Solingen aktiviert und dann nach Beispiel 2 metallisiert bzw. mit Leiterbahnen versehen. Man bekommt eine Leiterplatte mit guter Metallhaftung (≧ 17,5 N/inch). Die Leiterbahnen bestehen den Lötbadtest.

Beispiel 4

Eine 45 % Glasfaser und 20 % $TiO_2$ verstärkte PPS-Platte wird in einem Bad bestehen aus

| | |
|---|---|
| 2 g | $Br_2$ |
| 1000 ml | $H_2O_{dest.}$ |

vorbehandelt, gewaschen und dann mit einem ionogenen Aktivator bestehend aus

| | |
|---|---|
| 1 g | $PdCl_2$ |
| 10 g | HCl (37 %ig) |
| 1000 ml | $H_2O_{dest.}$ |

aktiviert, nach Beispiel 1 sensibilisiert. Diese Platte wird anschließend mit einer partiellen Maske (Siebdruckverfahren) versehen, in einem chemischen Metallisierungsbad mit 15 µm Cu-Auflage versehen und anschließend bei 160°C 1 Stunde getempert.

Man bekommt eine nach dem Volladditivverfahren hergestellte Leiterplatte mit einer guten Metallhaftfestigkeit. Diese Leiterplatte läßt sich in gängigen Lötbädern bei etwa 260°C löten.

Beispiel 5

Eine Leiterplatte nach Beispiel 1 wird in einem Bad bestehend aus

| | |
|---|---|
| 5 g | $Na_2Cr_2O_7$ |
| 600 g | $H_2SO_{4konz.}$ |
| 150 g | $H_3PO_{4konz.}$ |

vorbehandelt, gewaschen und getrocknet mit einer Aktivierungslösung bestehend aus

| | |
|---|---|
| 0,2 g | $Na_2PdCl_4$ |
| 0,8 g | 1,4,7,10,13-Pentaoxycyclododecan |
| 1000 ml | $CCl_3$-$CH_3$ bei RT nach Sprühverfahren partiell aktiviert und anschließend nach Beispiel 1 sensibilisiert bzw. nach Beispiel 2 metallisiert und getempert. |

Man bekommt eine nach dem Volladditivverfahren hergestellte Leiterplatte mit einer Metallhaftung ≧ 25 N/inch. Die Metallauflage besteht problemlos den Lötbadtest.

Beispiel 6

Eine 300 x 100 x 3 mm große PPS-Platte, bestehend aus 20 Gew.-$TiO_2$, 30 Gew.-% Glasfaser (3 mm) und PPS der mittleren Molmasse 25 000 mit -COOH Endgruppen wird 15 Min. in einem Bad bestehend aus

| | |
|---|---|
| 1000 ml | $CF_3COOH$ |
| 750 ml | $H_2O_2$ |

behandelt, mit $H_2O_{dest.}$ gewaschen, getrocknet,
in einem Bad bestehend aus

| | |
|---|---|
| 1000 ml | Ethanol |
| 2 g | $AlCl_3$ |
| 1 g | Bisbenzonitrilpalladium-II-chlorid |

5 Min. aktiviert, mit $H_2O_{dest.}$ gewaschen und dann in einem chemischen Verkupferungsbad der Fa. Schering AG, D-1000 Berlin, mit einer 1 µm starker Cu-Auflage versehen, die Cu-Auflage auf galvanischem Wege auf 40 µm verstärkt und anschließend bei 170°C 1 h getempert.

Man bekommt eine Verbundplatte mit einer sehr guten Metallhaftung.

Beispiel 7

Eine 300 x 100 x 3 mm große PPS-Platte, bestehend aus 20 Gew.-% $MgCO_3$, 40 Gew.-% Glasfasern (~ 3 mm) und PPS der mittleren Molmasse 25 000 mit -COOH Endgruppen nach Beispiel 6 oxidativ behandelt, aktiviert und metallisiert bzw. die Metallauflage mit galvanischem Ni auf 40 μm verstärkt und anschließend bei 135°C 90 Minuten getempert. Man bekommt eine Verbundplatte mit sehr guter Metallhaftung.

## Patentansprüche

1. Verfahren zur naßchemischen Metallisierung von Formkörpern aus füllstoffhaltigen, gegebenenfalls faserverstärkten Polyarylensulfiden ohne Strahleneinwirkung und ohne Vorbehandlung mit organischen Lösungsmitteln, Flammen und/oder mechanischen Aufrauhvorrichtungen, dadurch gekennzeichnet, daß man auf die Formkörper vor der Aktivierung ein Glas nicht-ätzendes Oxidationsmittel einwirken läßt und daß die Formkörper aus solchen Polyarylensulfiden bestehen, die als Füllstoffe Titandioxid und/oder Magnesiumcarbonat enthalten.

2. Verfahren nach Anspruch 1, dadurch gekennzeichnet, daß als Füllstoff Magnesiumcarbonat eingesetzt werden.

3. Verfahren nach Anspruch 1, dadurch gekennzeichnet, daß die Aktivierung mit metallorganischen Komplexverbindungen durchgeführt wird.

4. Verfahren nach Anspruch 1, dadurch gekennzeichnet, daß als Oxidationsmittel Bromlösungen, konz. Schwefelsäure oder Chromschwefelsäure oder deren Gemische mit Phosphorsäure oder organische Persäuren eingesetzt werden.

5. Verfahren gemäß Anspruch 1, dadurch gekennzeichnet, daß die Formkörper zum Aufbau von elektrischen Leiterplatten nach der Additiv- oder Semiadditivmethode partiell metallisiert werden.

6. Leiterplatten erhalten gemäß Verfahren des Anspruchs 5.

## Claims

1. A process for the wet chemical metallisation of moulded articles of filler-containing, optionally fibre reinforced polyarylene sulphides without the action of irradiation and without preliminary treatment with organic solvents, flames and/or mechanical roughening devices, characterised in that the moulded articles are subjected to the action of a glass of non-corrosive oxidising agents before activation and in that the moulded articles consist of polyarylene sulphides containing titanium oxide and/or magnesium carbonate as fillers.

2. A process according to claim 1, characterised in that the filler used is magnesium carbonate.

3. A process according to claim 1, characterised in that the activation is carried out with organometallic complex compounds.

4. A process according to claim 1, characterised in that the oxidising agents used are bromine solutions, conc. sulphuric acid or chromosulphuric acid or mixtures thereof with phosphoric acid or organic peracids.

5. A process according to claim 1, characterised in that the moulded articles are partially metallised for the construction of printed circuit boards by the additive or semi-additive process.

6. Printed circuit boards obtained by the process according to claim 5.

## Revendications

1. Procédé pour la métallisation chimique par voie humide de corps moulés en sulfures de polyarylènes contenant des charges, éventuellement renforcés par des fibres de verre, sans l'action de rayonnements et sans prétraitement par des solvants organiques, des flammes et/ou des appareils de grenage mécaniques, caractérisé en ce que l'on fait agir sur les pièces moulées avant l'activation un agent oxydant n'attaquant pas le verre et en ce que les corps moulés consistent en sulfures de polyarylènes qui contiennent comme charges du dioxyde de titane et/ou du carbonate de magnésium.

2. Procédé selon la revendication 1, caractérisé en ce que l'on utilise comme charge du carbonate de magnésium.

3. Procédé selon la revendication 1, caractérisé en ce que l'activation est mise en oeuvre avec des composés complexes organométalliques.

4. Procédé selon la revendication 1, caractérisé en ce que l'on utilise comme agents oxydants des solutions

de brome, l'acide sulfurique concentré ou le mélange sulfochromique ou leurs mélanges avec l'acide phosphorique ou des peracides organiques.

5. Procédé selon la revendication 1, caractérisé en ce que les corps moulés sont métallisés par la méthode additive ou semi-additive pour la construction de plaquettes conductrices électriques.

6. Plaquettes conductrices obtenues par le procédé selon la revendication 5.